# EUROPEAN PATENT APPLICATION

(11) **EP 3 627 702 A1**
(43) Date of publication of application: **25.03.2020**
(21) Application number: 18196031.1
(22) Date of filing: 21.09.2018
(51) Int. Cl.: H03K 17/082

(54) **DETERMINING AN OPERATING CONDITION OF A TRANSISTOR**

(71) Applicant: Maschinenfabrik Reinhausen GmbH, 93059 Regensburg (DE)
(72) Inventor: Wilcock, Matthew, Cambridge, CB1 3HL (GB)

(57) **Abstract**

A power electronic system comprises a transistor (T) and a feedback device (F) connected between gate (G1) and collector (C) of the transistor (T) for providing a negative feedback. The system comprises an evaluation unit (EU) configured to determine a junction temperature of the transistor (T) and/or an on-state current of the transistor (T) depending on a control voltage of the transistor (T).

## Description

The invention relates to a power electronic system with a transistor and to a method for determining an operating condition of a transistor, more specifically a junction temperature or an on-state current of the transistor.

In power electronic systems, for example power converters, the junction temperature of power semiconductor devices is a critical quantity setting a limit on system operation. Exceeding an absolute limit may be regarded as catastrophic and thermal behavior throughout the lifetime of the system affects reliability and rate of degradation. Furthermore, high junction temperatures or high on-state currents may cause device failures, especially because the currents and voltages switches by means of power electronic systems may be very high. In power electronics systems, several power semiconductor devices may be connected in parallel to allow operation at the desired currents. Therefore, also distribution of on-state currents to parallel devices may be of interest.

Existing approaches to determine junction temperature may use on-chip sensing diodes. To determine the on-state current, an auxiliary emitter cell carrying a small proportion of the device current may be connected in series with a temperature sense resistor. In both cases, a hardware architecture of the power converter is complex and requires dedicated sensor elements.

It is therefore an objective of the present invention to provide an improved concept for determining an operating condition of a transistor of a power electronic system that allows for a simpler structure of the power electronic system.

This objective is achieved by the subject-matter of the independent claims. Further implementations and embodiments are subject-matter of the dependent claims.

The improved concept is based on the idea to prevent the transistor from reaching or staying in a saturation state, measuring a control voltage of the transistor and exploiting the fact that the control voltage represents a temperature-sensitive electrical parameter, TSEP, as well as a current-sensitive electrical parameter, CSEP, if the saturation state is avoided.

According to the improved concept, a power electronic system is provided. The system comprises a transistor, in particular an insulated-gate bipolar transistor, IGBT, and a feedback device connected between a control terminal of the transistor and a collector terminal of the transistor for providing a negative feedback to the transistor. The system comprises an evaluation unit configured to determine a junction temperature of the transistor and/or an on-state current of the transistor depending on a control voltage, in particular a gate voltage, of the transistor.

If the feedback device is enabled, it provides the negative feedback to the transistor, in particular IGBT, in order to prevent the transistor from reaching a saturation state. In case the transistor is not in the saturation state, the feedback device is disabled. In cases where the transistor approaches or is in the saturation state, the feedback device is enabled resulting in a reduction of a gate-emitter voltage of the transistor. This causes the collector-emitter voltage to rise, depleting a MOS region of the transistor of excess carriers and thus greatly reducing a stored charge in a surrounding region. When the transistor is switched off from this state, that is while the feedback device is enabled, a switching speed may be significantly increased and switching loses may be significantly reduced. It is pointed out that the feedback device is not necessarily enabled in case the transistor approaches or is in saturation. Rather, it may be enabled only in specific cases.

According to several implementations, the feedback device is enabled before the transistor is turned off, in particular during a predefined period or at a predefined instance before the transistor is turned off, in particular several µs or several tens of µs, for example 5µs to 50µs, for example 5µs to 15µs, for example 10µs, before the transistor is turned off.

In this way, the transistor is prevented from reaching the saturation state or driven out of the saturation state as described. Consequently, the control voltage of the transistor is a TSEP and a CSEP, which is not the case during saturation of the transistor.

Therefore, the on-state current and/or junction temperature may be determined in a particularly simple way, namely from the control or gate voltage, which is controlled anyway for the operation of the power electronic system.

The control voltage is in particular determined, for example measured or determined based on a measurement, while the negative feedback is provided, in particular while the feedback device is enabled.

According to several implementations of the power electronic system, the feedback device comprises at least one diode, for example exactly one diode or two or more diodes coupled in series to each other.

According to several implementations, the feedback device is enabled, if a voltage drop over the feedback device is greater than a threshold value, in particular a breakdown voltage or a forward threshold voltage of the at least one diode, and disabled otherwise.

According to several implementations, the at least one diode comprises a Schottky diode, a PN diode or a PIN diode.

According to several implementations, a cathode of the at least one diode is connected to the collector of the transistor directly or indirectly, that means without or with further electronic components in between, respectively.

According to several implementations, the power electronic system comprises a control element connected between the control terminal of the transistor and the feedback device, in particular to an anode of the at least one diode. The control element has a controllable resistance.

According to several implementations, the feedback device is enabled if the control element is turned on, in particular is conducting, in particular has a minimum resistance. The feedback device is disabled if the control element is turned off, in particular is not conducting, in particular has a maximum resistance.

According to several implementations, the control element comprises a further transistor, in particular a field effect transistor, FET, for example a MOSFET or a JFET.

According to several implementations, the power electronic system comprises a control unit for controlling a resistance of the control element, for example by controlling a control voltage of the further transistor.

According to several implementations, the evaluation unit is configured to determine the junction temperature of the transistor depending on the control voltage of the transistor and an on-state current of the transistor. The on-state current may be measured directly or indirectly and may for example be predetermined.

According to several implementations, the evaluation unit is configured to determine the on-state current of the transistor depending on the control voltage of the transistor and the junction temperature of the transistor. Such implementations use a predetermined value for the junction temperature. The junction temperature may for example be predetermined or may be estimated based on a thermal model or based on one or more TSEPs apart from the on-state voltage or may be obtained from a look-up table.

One advantage of such implementations is that an appropriate turn-off gate resistor for the transistor may be selected based on the determined on-state voltage.

According to several implementations, the on-state current is given by Iₒₙ = K * (V_{c} - V_{T})^2, wherein Iₒₙ is the on-state current, V_{c} is the control voltage, V_{T} is a threshold voltage, in particular gate threshold voltage, and K is a factor incorporating for example a conductance of the transistor, in particular a MOS part of the transistor. The gate voltage VT and the factor K both depend on the junction temperature.

According to several implementations, the evaluation unit is configured to determine the on-state current of the transistor and the junction temperature of the transistor depending on the control voltage of the transistor and an on-state voltage of the transistor. The on-state voltage may be measured directly or indirectly, in particular while the feedback device is disabled, for example before the feedback device is enabled.

In such implementations, knowing the on-state voltage allows to exploit both the control voltage and, with the feedback device disabled, the on-state voltage being a TSEP and a CSEP at the same time. In addition to the advantages described above, this is particularly valuable for validating a current sharing and a thermal management of the transistor and further power semiconductor devices coupled in parallel to the transistor.

According to several implementations, the system comprises a drive unit configured to control a switching behavior of the transistor, in particular to turn the transistor on or off.

According to several implementations, the drive unit is configured to turn the transistor off while the feedback device is enabled, in particular, after the feedback device is enabled.

According to several implementations, the system comprises a delay element, in particular a programmable delay element coupled to the drive and the control unit. The delay element is configured to delay turning off the transistor with respect to enabling the feedback device.

According to several implementations, the delay lies in the order of several µs or several tens of µs, for example in the range of 5µs to 50µs, for example in the range of 5µs to 15µs, for example 10µs.

According to several implementations, the drive unit may comprise the control unit.

According to several implementations, the drive unit may comprise the feedback device.

According to several implementations, the power electronic system comprises a power converter, the power converter comprising the transistor as a switching element for an operation of the power converter.

According to several implementations, the evaluation unit is arranged separately from the power converter. Alternatively, the evaluation unit may be comprised by the power converter.

According to the improved concept, also a method for determining an operating condition of a transistor of a power electronic system is provided. According to the method, a negative feedback is provided to the transistor to prevent the transistor from reaching a saturation state or from staying in the saturation state. A control voltage of the transistor is measured while the negative feedback is provided, in particular while the feedback device is enabled. The operating condition, in particular including a junction temperature of the transistor and/or an on-state current of the transistor, is determined depending on the control voltage.

According to some implementations of the method, the junction temperature is determined depending on a control voltage and on a predetermined value for the on-state current.

According to some implementations of the method, the on-state current is determined depending on the control voltage and a predetermined value for the junction temperature.

According to some implementations of the method, an on-state voltage of the transistor is measured while the negative feedback is not provided, in particular while the feedback device is disabled. The junction temperature and/or the on-state current is determined depending on the control voltage and the on-state voltage.

Further implementations of the method according to the improved concept follow readily from the various implementations and embodiments of the power electronic system according to the improved concept and vice versa. In particular, individual or several components or arrangements described with respect to the system may be implemented accordingly for performing the method according to the improved system.

In the following, the invention is explained in detail with respect to exemplary implementations by reference to the drawings. Components that are functionally identical or have an identical effect may be denoted by identical reference signs. Identical components or components with identical functions or effects may be described only with respect to the figure where they occur first. Their description is not necessarily repeated in subsequent figures.

In the drawings,
- Figure 1: shows a block diagram of an exemplary embodiment of a power electronic system according to the improved concept; and
- Figure 2: shows a block diagram of a further exemplary embodiment of a power electronic system according to the improved concept.

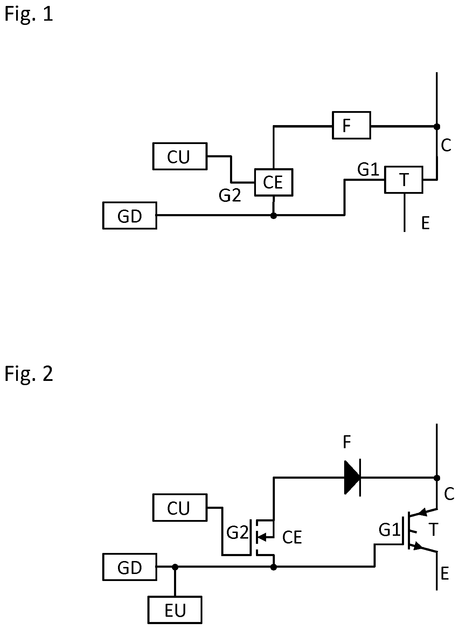

Figure 1 shows a block diagram of an exemplary embodiment of a power electronic system according to the improved concept. The system comprises a transistor T and a feedback device F connected between a collector terminal C and a control terminal G1 of the transistor T. The transistor T may for example be comprised by a power converter (not shown).

Depending on the type of the transistor T, the system may or may not comprise a control element CE connected between the feedback device F and the control terminal G1 of the transistor T. The system may then comprise a control unit CU connected to a control terminal G2 of the control element CE for controlling a resistance of the control element CE.

Optionally, the system may comprise a drive unit GD for controlling a control voltage applied to the control terminal G1 of the transistor T. The drive unit GD may comprise an evaluation unit (not shown in Figure 1) configured to receive a control voltage applied at the gate G1 of the transistor T. Alternatively, the evaluation unit may be implemented separately from the drive unit GD.

Figure 2 shows a block diagram of a further exemplary embodiment of a power electronic system according to the improved concept. The embodiment of Figure 2 is based on the embodiment of Figure 1, wherein the control element CE comprises a MOSFET (the circuit symbol for an n-channel enrichment type MOSFET is chosen merely as a non-limiting example), the feedback device F comprises a diode and the transistor T comprises an IGBT (the circuit symbol for an n-channel depletion type IGBT is chosen merely as a non-limiting example). Consequently, the control terminals G1, G2 are gate terminals G1, G2 and the control voltages of the transistor T and the control element CE are respective gate voltages. The embodiment of Figure 2 may comprise an evaluation unit EU connected to receive a gate voltage applied at the gate terminal G1 of the transistor T.

The operation of a system according to the improved concept is described in the following with respect to Figure 2. However, the more general embodiments of Figure 1 operate in an analogous way.

During operation of the power converter, the drive unit GD may control switching of the transistor T, that is turning the transistor T on or off, according to a switching scheme of the power converter by controlling a gate voltage at the gate G1 of the transistor T.

To reduce excess charges in a MOS region of the transistor T, the feedback device F is utilized to prevent the transistor T from reaching a saturation state of the transistor T or driving the transistor T out of the saturation state.

To this end, the control unit CU may apply or change the gate voltage at the gate G2 of the control element CE in order to reduce the resistance of the control element CE, that is to turn the control element CE on. Therefore, a gate-emitter voltage of the transistor T is reduced and a collector-emitter voltage of the transistor T rises, depleting a MOS region of the transistor T of excess carriers.

By reducing the excess carriers, the gate voltage of the transistor T is temperature sensitive as well as sensitive to an on-state current of the transistor T.

The evaluation unit EU is configured to determine a junction temperature of the transistor T or the on-state current of the transistor T depending on the gate voltage at the gate terminal G1 of the transistor T.

In particular, the evaluation unit EU may use a measured value of the gate voltage at the gate terminal G1 and a predetermined value of the on-state current to determine the junction temperature. In addition or alternatively, the evaluation unit EU may use a measured value of the gate voltage at the gate terminal G1 and a predetermined value of the junction temperature to determine the on-state current. In addition or alternatively, the evaluation unit EU may be configured and connected to receive an on-state voltage, in particular emitter-collector voltage, of the transistor T and to use respective measured values of the gate voltage at the gate terminal G1 and the on-state voltage to determine the determine the junction temperature and the on-state current.

By means of a power electronic system or method according to the improved concept, junction temperature and/or on-state current of a power transistor may be determined with a particularly simple setup. In addition, the switching losses of the transistor may be reduced. To achieve this, neither modification of the transistor nor a complex gate drive is required. The improved concept or certain aspects of it may have valuable uses with semiconductor devices not described herein, for example devices based on silicon carbide.

### Reference signs

- T: transistor
- G1, G2: control terminals
- C: collector terminal
- E: emitter terminal
- F: feedback device
- CE: control element
- CU: control unit
- GD: drive unit

## Claims

1. Power electronic system comprising
- a transistor (T) and a feedback device (F) connected between a control terminal (G1) of the transistor (T) and a collector terminal (C) of the transistor for providing a negative feedback to the transistor (T); and
- an evaluation unit (EU) configured to determine a junction temperature of the transistor (T) or an on-state current of the transistor (T) depending on a control voltage of the transistor (T).

2. Power electronic system according to claim 1, wherein the transistor (T) is an insulated-gate bipolar transistor, IGBT.

3. Power electronic system according to one of claims 1 or 2, wherein the feedback device (F) comprises at least one diode.

4. Power electronic system according to claim 3, wherein a cathode of the at least one diode is connected to the collector terminal (C) of the transistor (T) directly or indirectly.

5. Power electronic system according to one of claims 1 to 4, further comprising a control element (CE) connected between the control terminal (G1) of the transistor and the feedback device (F), the control element (CE) having a controllable resistance.

6. Power electronic system according to claim 5, wherein the control element (CE) comprises a further transistor, in particular a field effect transistor, FET.

7. Power electronic system according to one of claims 5 or 6, further comprising a control unit (CU) for controlling a resistance of the control element (CE).

8. Power electronic system according to one of claims 1 to 7, wherein the evaluation unit (EU) is configured to determine the junction temperature of the transistor (T) depending on the control voltage of the transistor (T) and an on-state current of the transistor (T).

9. Power electronic system according to one of claims 1 to 8, wherein the evaluation unit is configured to determine the on-state current of the transistor (T) depending on the control voltage of the transistor (T) and the junction temperature of the transistor (T).

10. Power electronic system according to one of claims 1 to 9, wherein the evaluation unit (EU) is configured to determine the on-state current of the transistor (T) and the junction temperature of the transistor (T) depending on the control voltage of the transistor (T) and an on-state voltage of the transistor (T).

11. Power electronic system according to one of claims 1 to 10 comprising a power converter, the power converter comprising the transistor (T) as a switching element for an operation of the power converter.

12. Method for determining an operating condition of a transistor (T) of a power electronic system, the method comprising
- providing a negative feedback to the transistor (T) to prevent the transistor (T) from reaching a saturation state or from staying in the saturation state;
- measuring a control voltage of the transistor (T) while the negative feedback is provided; and
- determining a junction temperature of the transistor (T) or an on-state current of the transistor (T) depending on the measured control voltage.

13. Method according to claim 12, wherein the junction temperature is determined depending on the control voltage and a predetermined value for the on-state current.

14. Method according to one of claims 12 or 13, wherein the on-state current is determined depending on the control voltage and a predetermined value for the junction temperature.

15. Method according to one of claims 12 to 14, further comprising
- measuring an on-state voltage of the transistor (T) while the negative feedback is not provided; and
- determining the junction temperature and/or the on-state current depending on the control voltage and the on-state voltage.
